(19) Europäisches Patentamt
European Patent Office
Office européen des brevets

(11) EP 1 762 945 B1

(12) **EUROPÄISCHE PATENTSCHRIFT**

(45) Veröffentlichungstag und Bekanntmachung des Hinweises auf die Patenterteilung:
**24.04.2019 Patentblatt 2019/17**

(51) Int Cl.:
***G06F 17/14*** *(2006.01)* ***G01R 27/28*** *(2006.01)*

(21) Anmeldenummer: **06015933.2**

(22) Anmeldetag: **31.07.2006**

(54) **Verfahren zur Transformation von im Frequenzbereich gewonnenen Messdaten in den Zeitbereichen**

Method for transforming to the time domain measured data obtained in the frequency domain

Procédé pour transformer dans le domaine temporel des données mesurées obtenues dans le domaine fréquentiel

(84) Benannte Vertragsstaaten:
**DE FR GB**

(30) Priorität: **08.09.2005 DE 102005042793**

(43) Veröffentlichungstag der Anmeldung:
**14.03.2007 Patentblatt 2007/11**

(73) Patentinhaber: **Rohde & Schwarz GmbH & Co. KG 81671 München (DE)**

(72) Erfinder: **Reichel, Thomas 85598 Baldham (DE)**

(74) Vertreter: **Körfer, Thomas et al Mitscherlich PartmbB Patent- und Rechtsanwälte Postfach 33 06 09 80066 München (DE)**

(56) Entgegenhaltungen:
**GB-A- 2 251 082**

- **MIYASHITA T ET AL: "Recovery of ultrasonic impulse response by spectral extrapolation" PROCEEDINGS OF THE 14TH INTERNATIONAL SYMPOSIUM ON ACOUSTICAL IMAGING, 22-25 APRIL 1985, THE HAGUE, THE NETHERLANDS, Bd. 14, 22. April 1985 (1985-04-22), Seiten 247-257, XP008082055**
- **MIYASHITA T ET AL: "High resolution acoustic impulse response in air with spectral extrapolation by linear prediction" PROCEEDINGS OF THE 1998 IEEE ULTRASONICS SYMPOSIUM, 5-8 OCTOBER 1998, SENDAI, JAPAN, Bd. 1, 5. Oktober 1998 (1998-10-05), Seiten 873-876, XP010330857 ISBN: 0-7803-4095-7**
- **GABRIEL W F: "Improved range superresolution via bandwidth extrapolation" RECORD OF THE 1993 IEEE NATIONAL RADAR CONFERENCE, 20-22 APRIL 1993, LYNNFIELD, MA, USA, 20. April 1993 (1993-04-20), Seiten 123-127, XP010067893 ISBN: 0-7803-0934-0**

EP 1 762 945 B1

**Beschreibung**

Die Erfindung betrifft ein Verfahren laut Oberbegriff des Hauptanspruches.

Messdaten, die beispielsweise mittels eines vektoriellen Netzwerkanalysators oder eines Sechs-Tor-Reflektormeters im Frequenzbereich gewonnen werden, müssen in der Hochfrequenzmesstechnik oftmals zur weiteren Analyse in den Zeitbereich transformiert werden. Die Transformation erfolgt dabei entweder mit Hilfe einer inversen FourierTransformation oder einer sogenannten inversen Chirp-z-Transformation. Durch die Transformation erhält man die Impulsantwort und nach Integration die manchmal aussagekräftigere Sprungantwort. Diese Darstellung im Zeitbereich bietet die Möglichkeit einer Lokalisierung von Störstellen z. B. bei der Optimierung von Anpassungen. Die zeitliche und räumliche Auflösung dieser Transformation im Zeitbereich ist jedoch begrenzt; sie ist umgekehrt proportional zur analysierten Frequenzbandbreite. In der messtechnischen Praxis erweist sie sich selbst bei Ausnutzung der Maximalbandbreite des verwendeten Messgerätes (z. B. Netzwerkanalysator bzw. Steckersystem) häufig als zu gering, so dass es großer Erfahrung bei der Interpretation des Ergebnisses bedarf bzw. eine Auswertung oftmals überhaupt nicht möglich ist.

Bei einem Verfahren dieser Art ist es bekannt, den Frequenzbereich der Messdaten vor der Transformation durch Extrapolation, beispielsweise durch lineare Prädikation, zu vergrößern (T. Miyashita et al.: "Recovery of ultrasonic impulse response by spectral extrapolation", Proceedings of the 14th International Symposium on Acoustical Imaging, 22-25 April 1985, The Hague, The Netherlands, Bd. 14, 22. April 1985, Seiten 247-257 T. Miyashita et al.: "High resolution acoustic impulse response in air with spectral extrapolation by linear prediction", Proceedings of the 1998 IEEE Ultrasonics Symposium, 5-8. October 1998, Sendai, Japan, Bd. 1 ISBN: 0-7803-4095-7, 5. Oktober 1998, Seiten 873-876 W. F. Gabriel: "Improved range superresolution via bandwidth extrapolation", Record of the 1993 IEEE National Radar Conference, 20-22. April 1993, Lynnfield, MA, USA, ISBN: 0-7803-0934-0, 20. April 1993, Seiten 123-127, GB-A-2 251 082). Für die Transformation wird hierbei das Verfahren der Bandpasstransformation benutzt, das lediglich den Betrag der Zeitbereichsantwort und eine schlechte zeitliche Auflösung liefert.

Um diesen Nachteil zu vermeiden, wird ausgehend von einem Verfahren laut Oberbegriff des Patentanspruches das Verfahren gemäß kennzeichnetem Teil dieses Anspruchs vorgeschlagen.

Gemäß Erfindung kann sowohl ein harmonisches Frequenzraster als auch ein nichtharmonisches Frequenzraster so aufbereitet werden, dass anschließend die Messdaten einer Tiefpasstransformation unterworfen werden können. Dadurch wird eine eindeutig bestimmte reelle Zeitbereichsantwort möglich, indem für ein harmonisches Frequenzraster der Frequenz 0 ein Wert zugeordnet wird und beziehungsweise für ein nichtharmonisches Frequenzraster durch Extrapolation in Richtung kleinerer Frequenzen die Lücke zwischen der Minimalfrequenz und der Frequenz 0 geschlossen wird. Auf diese Weise wird auch von Anfang an eine bessere zeitliche Auflösung erreicht.

Die Erfindung wird im Folgenden anhand schematischer Zeichnungen an zwei Ausführungsbeispielen näher erläutert:

Fig. 1       zeigt das Prinzip der linearen Prädiktion am Beispiel einer Sinusfunktion,

Fig. 2       zeigt die Anwendung des erfindungsgemäßen Verfahrens am Beispiel einer Leitung mit gestuftem Innendurchmesser,

Fig. 3-6       zeigen die Mess- und Auswertergebnisse für dieses Beispiel nach Fig. 2,

Fig. 7       zeigt die Anwendung des erfindungsgemäßen Verfahrens bei einer längshomogenen Leitung mit einer Querkapazität,

Fig. 8-11       zeigen wieder die zugehörigen Mess- und Auswertergebnisse für die Anordnung nach Fig. 7.

Zur Extrapolation des beispielsweise mittels eines vektoriellen Netzwerkanalysators im Frequenzbereich gewonnenen Messdatensatzes vor dessen Transformation in den Zeitbereich wird der Frequenzbereich des Messdatensatzes vorzugsweise durch lineare Prädiktion vergrößert. Dazu wird die Folge von komplexen Messdaten (Übertragungskoeffizienten bzw. Reflexionskoeffizienten) getrennt für Realteil und Imaginärteil der linearen Prädiktion unterworfen, wie sie beispielsweise in dem Buch von Kammeyer/Kroschel "Digitale Signalverarbeitung" auf den Seiten 354 ff näher beschrieben ist.

Das Bildungsgesetz der linearen Prädiktion ist einfach, und zwar wird jeder neu hinzugekommene Wert als Linearkombination der Vorgänger gebildet, d. h.

$$y_{i+1} = \sum_{V=0}^{M} a_{i-v} y_{i-v}$$

Die Prädiktionskoeffizienten $a_{i-v}$ können mit verschiedenen mathematischen Verfahren, z. B. der Autokorrelationsmethode oder dem Burg-Algorithmus, aus dem vorhandenen Datensatz gewonnen werden. Der Grad M ist frei wählbar, allerdings muss er stets kleiner als die Zahl der Messwerte sein. Wenn die für die Berechnungen benötigte Zeit unkritisch ist, wird M bei der erfindungsgemäßen Anwendung so groß wie möglich gewählt.

Da sich die lineare Prädiktion besonders gut zur Extrapolation harmonischer Schwingungen eignet, ist sie das Mittel der Wahl für die Frequenzbereichsantwort linearer elektrischer Netzwerke, welche sich als Überlagerung der von den Störstellen angeregten harmonischen Funktionen darstellen lässt.

Beispiel:

Um eine Sinusfunktion fortzusetzen, benötigt man lediglich zwei Prädiktionskoeffizienten.

Die Sinusschwingung

$$y_i = 2\sin(3 + 0.5i) ,$$

lässt sich zum Beispiel durch das Bildungsgesetz

$$y_{i+1} = 1.75517 y_i - y_{i-1}$$

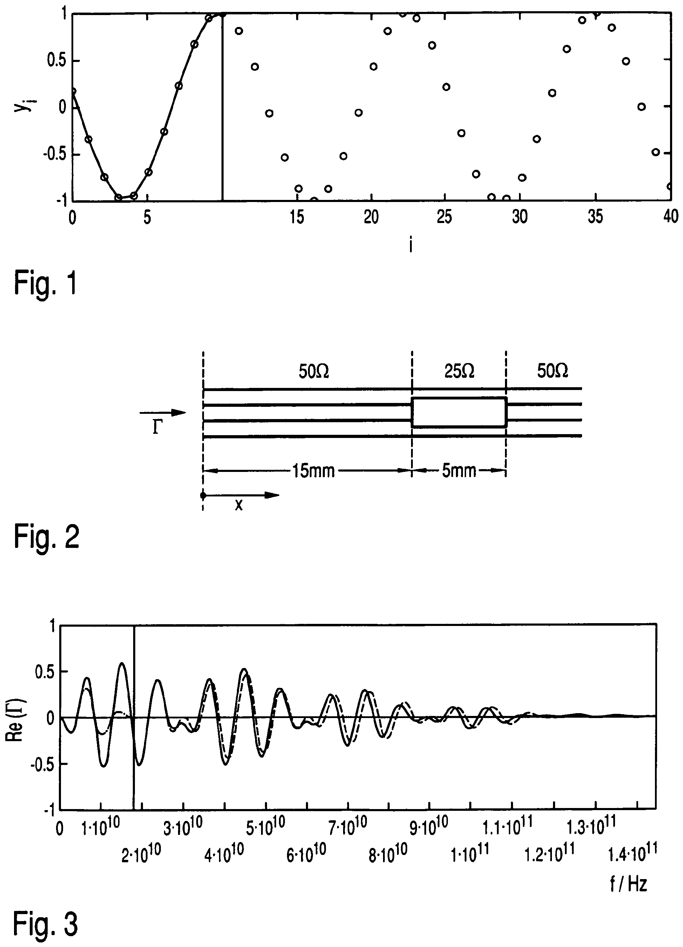

aus den Anfangswerten beliebig weiterführen, so wie dies in Fig. 1 dargestellt ist.

Der mit der Extrapolation verbundene Vorteil wird durch zwei Beispiele verdeutlicht, welche die Zeitbereichsantwort nach konventioneller Transformation sowie nach vorhergehender Prädiktion zeigen.

Beim ersten Beispiel handelt es sich um den Eingangsreflexionsfaktor einer Leitung mit gestuftem Innendurchmesser, d. h. einer Leitung, deren Wellenwiderstand über eine gewisse Länge (5mm) vom Bezugswellenwiderstand abweicht (Fig. 2). Streukapazitäten am Anfang und am Ende dieses Abschnitts sollen vernachlässigt werden. Die Qualität der Zeitbereichstransformation wird sich daran zeigen, wie exakt sich Anfang und Ende dieses Abschnitts bestimmen lassen. Die Leitung soll am rechten Ende entweder mit dem Bezugswellenwiderstand von 50 Ω abgeschlossen sein oder sich unendlich weit ausdehnen (nicht dargestellt).

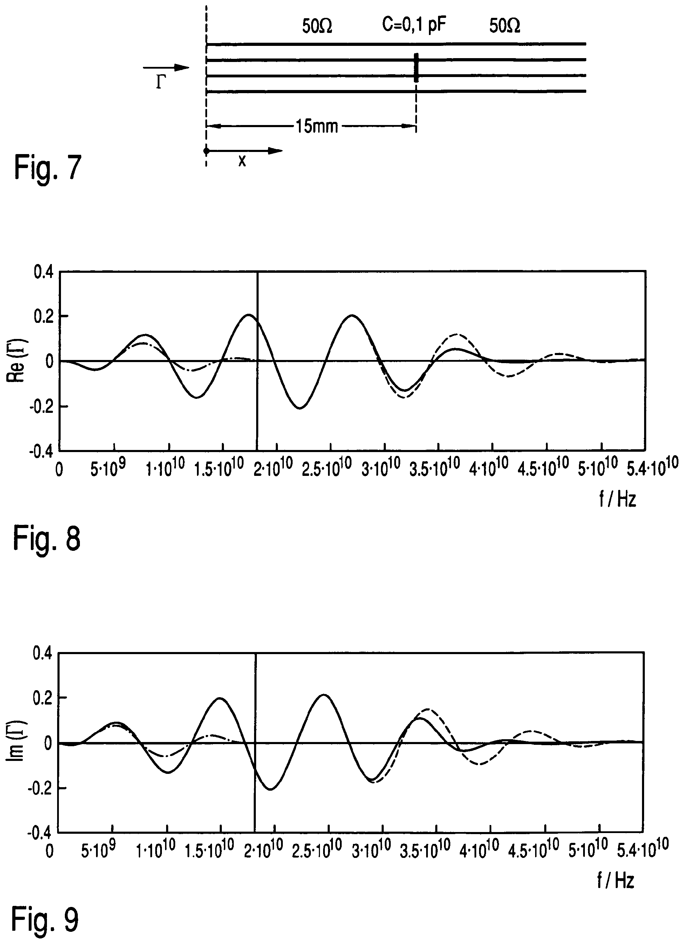

In Fig. 3 bis 6 sind die Mess- bzw. Auswerteergebnisse für die Anordnung nach Fig. 2 dargestellt. Sie werden zusammen mit den entsprechenden Messergebnissen für die Anordnung nach Fig. 7 erläutert.

Im Beispiel nach Fig. 7 wird eine längshomogene Leitung an einer bestimmten Position mit einer Querkapazität C belastet. Auch hier soll die Leitung am rechten Ende entweder mit dem Bezugswellenwiderstand von 50 Ω abgeschlossen sein oder sich unendlich weit ausdehnen.

Die "Messdaten" für beide Beispiele wurden synthetisch auf der Basis eines mathematischen Modells berechnet. Es handelt sich dabei um die komplexen Reflexionskoeffizienten Γ am Eingang der beiden Leitungen, jeweils mit einem Frequenzabstand von 50 MHz, beginnend bei 50 MHz (harmonisches Frequenzraster). Die in den Diagrammen dargestellten Kurven sind wie folgt gekennzeichnet:

strichpunktiert: Auf einem Messdatensatz bis 18 GHz basierend, der konventionell in den Zeitbereich transformiert wird (Tiefpasstransformation).

gepunktet: Auf einem Messdatensatz bis 54 GHz (Fig. 7) bzw. 144 GHz (Fig. 2) basierend, der konventionell in den Zeitbereich transformiert wird (Tiefpasstransformation).

durchgehend: Ebenfalls auf einem Messdatensatz bis 18 GHz basierend, der allerdings vor der Transformation um einen Faktor V extrapoliert wird (lineare Prädiktion mit Autokorrelationsmethode). V beträgt 3 für das Beispiel nach Fig. 7 und 8 für das Beispiel nach Fig. 2, d. h. der virtuelle Frequenzbereich erstreckt sich bis 54 GHz bzw. 144 GHz. Durch Vergleich mit den gepunkteten Kurven kann man die Abweichungen gegenüber der exakten Lösung (für die jeweilige Bandbreite) erkennen.

Fig. 3 und Fig. 8: Die Figuren zeigen den Realteil des gewichteten Reflexionskoeffizienten als Funktion der Frequenz (in Hertz) vor der Transformation. Als Fensterfunktion wurde einheitlich ein von-Hann-Fenster verwendet.

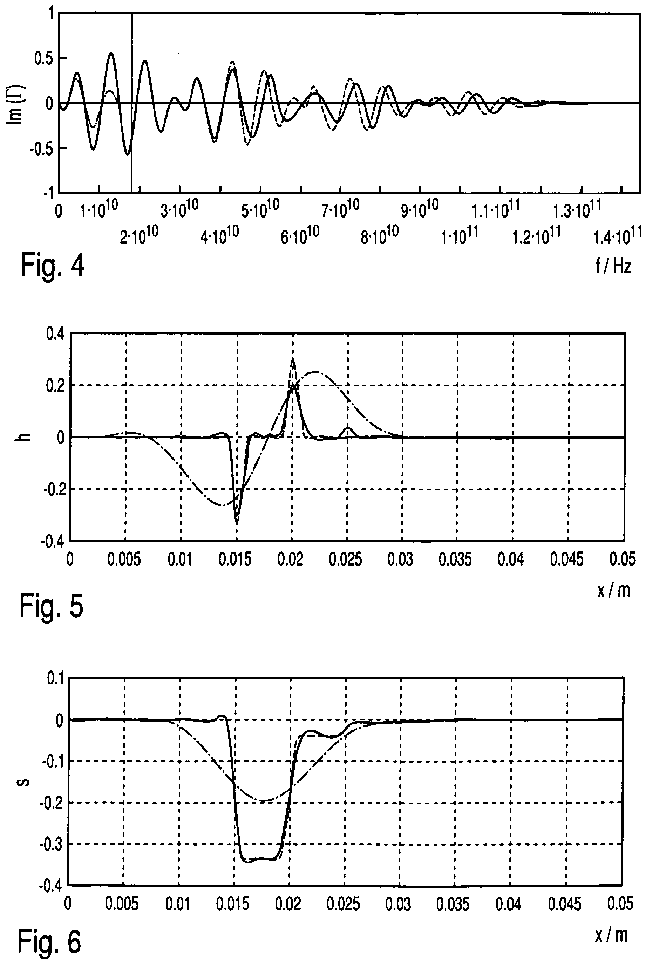

Fig. 4 und Fig. 9: Die Figuren zeigen den Imaginärteil des gewichteten Reflexionskoeffizienten als Funktion der Frequenz (in Hertz) vor der Transformation. Als Fensterfunktion wurde einheitlich ein von-Hann-Fenster verwendet.

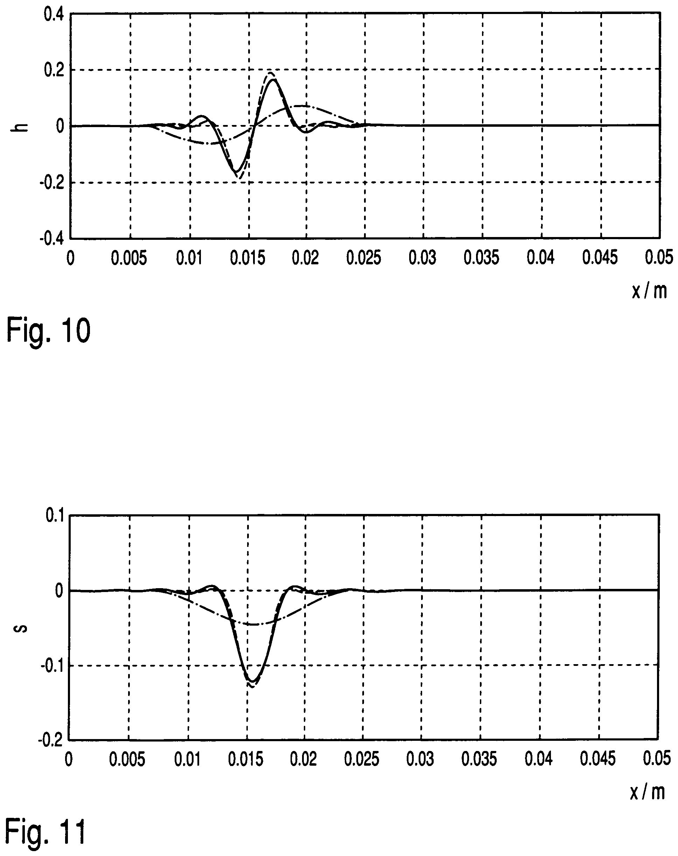

Fig. 5 und Fig. 10: Die Figuren zeigen die Zeitbereichstransformierte (Impulsantwort) h des Reflexionskoeffizienten als Funktion der Leitungsposition x in Längsrichtung (in der Einheit Meter, vom Leitungsanfang aus gerechnet). Das höhere Auflösungsvermögen, das mit den extrapolierten Datensätzen erzielt werden kann, ist deutlich zu erkennen, ferner die geringe Abweichung gegenüber jenen Ergebnissen (punktiert), welche auf Messdatensätzen über die volle Bandbreite beruhen. Anfang und Ende des gestuften Abschnitts sind genau bestimmbar.

Fig. 6 und Fig. 11: Diese Figuren zeigen die Sprungantwort s, welche durch Integration aus der Impulsantwort hervorgeht. Die Auswertung der Sprungantwort erweist sich in Anordnungen nach Fig. 2 als besonders nützlich, weil sich daraus der Impedanzverlauf der Leitung quasi ablesen lässt. Auch hier lässt sich der Vorteil und die hohe Genauigkeit des erfindungsgemäßen Verfahrens deutlich erkennen.

**Patentansprüche**

1.  Verfahren zur Transformation von im Frequenzbereich gewonnenen Messdaten in den Zeitbereich, bei dem vor der Transformation der Frequenzbereich der Messdaten durch Extrapolation, insbesondere durch lineare Prädikation, vergrößert wird,

**dadurch gekennzeichnet,**

**dass** für Messdaten, denen ein harmonisches Frequenzraster zu Grunde liegt, die Extrapolation der Messdaten zu höheren Frequenzen durchgeführt wird,

und **dass** für Messdaten, denen kein harmonisches Frequenzraster zu Grunde liegt, die Extrapolation der Messdaten zu niedrigeren Frequenzen und gegebenenfalls auch zu höheren Frequenzen durchgeführt wird,

und **dass** diese Messdaten dann vor der Transformation in den Zeitbereich einer Tiefpasstransformation unterworfen werden.

## Claims

1. Method for transforming measurement data obtained in the frequency domain to the time domain, in which prior to the transformation the frequency range of the measurement data is increased by extrapolation, in particular by linear prediction,

   **characterised in that**

   for measurement data which are based on a harmonic frequency raster, the measurement data are extrapolated to higher frequencies,

   and **in that** for measurement data which are not based on any harmonic frequency raster, the measurement data are extrapolated to lower frequencies and optionally to higher frequencies as well,

   and **in that** these measurement data are then subjected to a low pass transformation prior to the transformation to the time domain.

## Revendications

1. Procédé pour transformer des données de mesure, obtenues dans le domaine fréquentiel, dans le domaine temporel, selon lequel, avant la transformation, le domaine fréquentiel des données de mesure est augmenté par extrapolation, en particulier par prédiction linéaire,

   **caractérisé en ce que**,

   pour des données de mesure basées sur une grille de fréquence harmonique, l'extrapolation des données de mesure est réalisée à des fréquences plus élevées,

   et **en ce que**, pour des données de mesure non basées sur une grille de fréquence harmonique, l'extrapolation des données de mesure est réalisée à des fréquences plus basses et le cas échéant également à des fréquences plus élevées,

   et **en ce que** ces données de mesure sont alors soumises à une transformation passe-bas avant la transformation dans le domaine temporel.

Fig. 1

Fig. 2

Fig. 3

Fig. 4

Fig. 5

Fig. 6

Fig. 7

Fig. 8

Fig. 9

Fig. 10

Fig. 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 2251082 A

**In der Beschreibung aufgeführte Nicht-Patentliteratur**

- **T. MIYASHITA et al.** Recovery of ultrasonic impulse response by spectral extrapolation. *Proceedings of the 14th International Symposium on Acoustical Imaging,* 22. April 1985, vol. 14, 247-257
- **T. MIYASHITA et al.** High resolution acoustic impulse response in air with spectral extrapolation by linear prediction. *Proceedings of the 1998 IEEE Ultrasonics Symposium,* 05. Oktober 1998, vol. 1, ISBN 0-7803-4095-7, 873-876

- **W. F. GABRIEL.** Improved range superresolution via bandwidth extrapolation. *Record of the 1993 IEEE National Radar Conference,* 20. April 1993, ISBN 0-7803-0934-0, 123-127